(19) Europäisches Patentamt
European Patent Office
Office européen des brevets

(11) Publication number: **0 191 220 B1**

(12) **EUROPEAN PATENT SPECIFICATION**

(45) Date of publication of patent specification: **24.04.91**

(51) Int. Cl.5: **C08F 10/02**, C08F 2/42

(21) Application number: **85306960.7**

(22) Date of filing: **30.09.85**

The file contains technical information submitted after the application was filed and not included in this specification

# (54) Method of deactivating ethylene polymerisation catalysts.

(30) Priority: **09.01.85 US 689953**

(43) Date of publication of application: **20.08.86 Bulletin 86/34**

(45) Publication of the grant of the patent: **24.04.91 Bulletin 91/17**

(84) Designated Contracting States: **BE DE FR GB IT NL**

(56) References cited:
**EP-A- 143 716**
**EP-A- 0 118 092**
**US-A- 4 105 609**

**Chemical Abstracts; vol.96, 1982, page 43, ref.no. 36263j; Columbus, Ohio, US**

(73) Proprietor: **QUANTUM CHEMICAL CORPORATION**
**11500 Northlake Drive**
**Cincinnati, OH 45249(US)**

(72) Inventor: **Hwang, Yu-Tang**
**1520 Ninth Street N.W.**
**Clinton, IA 52732(US)**
Inventor: **Pebsworth, Lloyd W.**
**920 12th Avenue S.**
**Clinton, IA 52732(US)**
Inventor: **Dombro, Robert A.**
**857 N. Marsha Drive**
**Palatine, IL 60067(US)**
Inventor: **Hoff, Raymond E.**
**244 South Oak**
**Palatine, IL 60067(US)**

(74) Representative: **Spencer, Graham Easdale et al**
**A.A. Thornton & CO Northumberland House**
**303-306, High Holborn**
**London WC1V 7LE(GB)**

**EP 0 191 220 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention is concerned generally with a method of terminating ethylene polymerization and copolymerization processes and, more specifically, with the deactivation of Ziegler catalysts used in such polymerization processes.

In polyethylene production generally, and particularly in the production of high density polyethylene (HDPE) or linear low density polyethylene copolymers (LLDPE) in high pressure reactors, it is necessary to terminate the polymerization reaction at a particular point in order to prevent the production of undesirable products, such as waxes and low molecular weight materials such as oligomers.

Typically in such processes, a catalyst comprising a transition metal compound, conventionally referred to as a "Ziegler catalyst", in association with an organometallic cocatalyst, is contacted with ethylene or ethylene and one or more l-olefin or diolefin comonomers having at least three carbon atoms, under conditions of moderate to high pressure and high temperature. Under such conditions, ethylene is a liquid and acts as a solvent for the product polymer.

Typically, the product is discharged from the reactor in the form of a stream of polymer solution into one or more relatively low pressure separators where unpolymerized monomer and comonomer are removed from the polymer solution by evaporation.

The stream of polymer solution is actively polymerizing as it leaves the reactor since catalyst components are still present in the stream. It is therefore necessary to terminate the polymerization reaction by deactivating the catalyst components in order to avoid the production of undesirable by-products.

A known means of terminating ethylene polymerization reactions is described in U.S. Patent 4105609. This patent describes the use of an alkali metal salt or alkaline earth metal salt of a carboxylic acid, such as calcium stearate, as a deactivating agent for a Ziegler catalyst.

Other prior art deactivation methods use such deactivating agents as humidified calcium stearate, salts of alkali metals, inorganic polybasic acids and water, or water combined with an alkaline earth metal or zinc salt of an aliphatic monocarboxylic acid containing from 6 to 22 carbon atoms. Still other known deactivating agents include aqueous non-ionic surfactants and flux-calcined diatomite.

However, none of these prior art methods of catalyst deactivation have been completely satisfactory in terminating ethylene polymerization and copolymerization processes.

We have now found that certain hydrotalcite materials are effective deactivators for such ethylene polymerization catalysts.

According to one aspect of the present invention, there is provided a method of homopolymerizing ethylene or interpolymerizing ethylene with one or more l-olefins or diolefins having at least three carbon atoms by subjecting the monomer(s) to polymerizing conditions in a reactor in the presence of a catalyst which comprises a transition metal derivative, and terminating the polymerization by adding a catalyst deactivator to the polymerization mixture or a part thereof, characterised in that the deactivator is a natural hydrotalcite mineral or synthetic hydrotalcite-like material.

According to another aspect of the invention, the deactivator is

(i) a natural hydrotalcite mineral,

(ii) a carbonate-free hydrotalcite or

(iii) a hydrotalcite which contains a surface active agent.

The deactivating agent and the products of reaction between the agent and the components of the catalyst remain in the polymer solution and act as halogen scavengers, thereby providing a corrosion inhibiting effect in the process equipment.

The catalyst is quickly and effectively deactivated by the method of the invention, thereby preventing complications such as the formation of waxes and oligomers.

The method of the invention is suitable for polymerizing or copolymerizing, in batch or continuous processes, ethylene or ethylene and one or more l-olefins or diolefins having at least three carbon atoms, under various conditions of pressure and temperature. The method of the invention is particularly suitable for polymerization processes using medium to high pressures and high temperatures. The preferred temperature range is from 130 °C to 300 °C with pressures preferably in the range of from 69-172MPa-(10,000 to 25,000 psig). Polymerization processes of this type are described in U.S. Patent 4105609.

The polymerization reaction may be carried out in a reactor of any convenient type, including, for example, stirred autoclave reactors and tubular reactors, or in a series of reactors of either the autoclave or tubular type. The polymerization conditions are preferably selected such that the reaction mixture of monomer, comonomer (if present), and polymer is homogeneous, i.e. the polymer is soluble in the reaction mixture.

If desired, chain transfer agents, such as hydrogen, or liquid diluents, such as liquid alkanes, can be

present in the reaction mixture.

As is well known in the art, when polymerization is effected to form a solution of the product polymer in liquefied monomer(s), the polymer solution can be discharged as a stream from the reactor into a separator or series of separators which operate at low pressures relative to that of the reactor, in which the polymer is obtained from the polymer solution by degassing, that is vaporisation of the unreacted monomer and comonomer, which are then recycled to the reactor.

The stream of polymer solution which is discharged from the reactor still contains catalyst components. The present invention broadly contemplates the use of catalysts comprising a transition metal compound, conventionally referred to as "Ziegler catalysts", in association with an organometallic cocatalyst, such as an alkyl aluminium compound.

Such two component catalysts are well known in the art and the use of such catalysts is not critical to the practice of the invention. In general, such catalysts contain a transition metal, preferably titanium and/or vanadium, together with a Group IIA metal compound, such as an organomagnesium compound, or an organoaluminium compound.

In a preferred embodiment of the invention, the selected deactivator is added directly to the actively polymerizing stream of polymer solution, for example by injection prior to degassing of the polymer solution. The deactivator may be introduced into the polymer stream in dry form, in admixture with water, or as a solution or suspension in an inert liquid diluent, such as mineral spirits. Preferably, the deactivator is added in slurry form in an inert liquid diluent.

The amount of deactivator added to the polymerization mixture must, of course, be sufficient to ensure deactivation of the catalyst and termination of polymerization. Deactivation is effected by the destruction of at least one of the constituents of the catalyst, that is the transition metal derivative and/or the organometallic cocatalyst. It is preferred to use sufficient deactivator to react with all of the metallic components of the catalyst. Preferably from 0.1 to 10 moles of deactivator are used for each mole of metal in the catalyst.

Deactivation of a Ziegler catalyst in an actively polymerizing mixture by the method of the invention results in rapid, effective deactivation of the polymerization reaction, thereby preventing the formation of undesirable by-products, such as waxes, and low molecular weight products, such as oligomers. The deactivating agent reacts with the metallic components of the Ziegler catalyst system and the reaction products and any unreacted deactivating agent remain in the polymer after monomer removal.

An important benefit of the invention is the halogen scavenging ability of the deactivators, which significantly inhibits corrosion of process equipment when the deactivator and its reaction products with the components of the catalyst system remain in the polymer. For example, chloride in the catalyst is effectively neutralised by the method according to the invention. The invention also provides ready control of the composition of the gases recycled to the reactor from the low pressure separators, thereby allowing ready control of the relative amounts of the constituents in the reactor.

The hydrotalcite material used as deactivator may be a natural mineral or a synthetic hydrotalcite-like material; it may be used in dried (calcined or anhydrous) or partially dried form. When it contains a surface active agent, the latter is preferably anionic.

The hydrotalcite materials used in the method of the invention are generally defined as "magnesium-aluminium-hydroxide carbonate hydrates", but they need not contain carbonates for the purposes of the present invention.

An example of a synthetic hydrotalcite is a material having the formula $Mg_6Al_2(OH)_{16}CO_3.4H_2O$. A synthetic hydrotalcite-like compound available from Kyowa Chemical Company Ltd. under the Trademark DHT-4A has the formula $Mg_{4.5}Al_2(OH)_{13}CO_3.3.5\ H_2O$. A form containing less water of hydration (i.e. less than 3.5 moles of water of hydration per mole of compound) is designated DHT-4AA.

One group of suitable carbonate free hydrotalcite-like materials have the formula

$$Mg_{1-x}Al_x(OH)_2A^{b-}_{x/b}.dH_2O,$$

in which x is greater than 0 and less than or equal to 0.5, d is zero or a positive number, b is a positive integer, and $A^{b-}$ is an anion having the valency of b. Such materials are described in U.S. Patents 4284762 and 4347353.

Synthetic hydrotalcites are described in detail in Clays and Clay Minerals , 28 , No. 1 at pages 50-56 (1980).

Another type of carbonate-free hydrotalcite material suitable for use in the method of the invention has the formula $Mg_{1-x}Al_x(OH)_{2+x}\ .aH_2O$, in which x is greater than zero and less than or equal to 0.5 and a is greater than or equal to zero and less than 2. This type of material is described in U.S. Patent 4379882.

Another carbonate-free synthetic hydrotalcite which is suitable for use in the method of the invention has the formula $Mg_{4.5}Al_2(OH)_{15}.3.5H_2O$.

In order that the invention may be more fully understood, the following examples are given by way of illustration.

## Examples

A series of ethylene/l-butene copolymerization reactions were carried out in a one-litre autoclave reactor equipped with a catalyst injector and a separate deactivator injector. Isopar H (supplied by Exxon) was used as a diluent. An alkyl aluminium cocatalyst liquid ethylene at 3.45MPa (500 psig), and 15% by weight of l-butene were placed in the reactor at 220° C and a titanium/magnesium catalyst was injected under nitrogen pressure. The rate of reaction was monitored and when maximum reactivity was achieved, the deactivator compound was injected under nitrogen pressure. The effectiveness of each deactivator was measured in terms of the number of seconds required after the deactivator had been injected into the active polymerization zone for the ethylene flow to fall to less than 5% compared with a blank test in which no deactivator was injected. The compound injected was considered to be an effective deactivator if it reduced the ethylene flow to less than 5% within 30 seconds of its injection into the polymerization mixture.

The following Table shows the results obtained:

**TABLE**

| Example | Deactivator | Mole Ratio Deactivator to Catalyst[b] | Ethylene Flow at Time of Deactivator Injection, % | Maximum Ethylene Flow Reached, % | Time to Deactivate Seconds[d] |
|---|---|---|---|---|---|
| 1 | None[a] | - | - | 55 | 120 |
| 2 | 220°C Dried Synthetic Hydrotalcite[c] | 0.1 | 33 | 72 | no effect |
| 3 | " | 0.15 | 30 | 55 | 33 |
| 4 | " | 0.25 | 31 | 41 | 32 |
| 5 | " | 1.0 | 27 | 72 | 23 |
| 6 | Synthetic Hydrotalcite[c] | 0.15 | n/a | n/a | 26 |
| 7 | " | 1.5 | 46 | 46 | 16 |
| 8 | $Mg_{4.5}AL_2(OH)_{15} \cdot 3.5H_2O$[e)] | 1 | >30 | >30 | <30 |

Footnotes to Table

a) Blank test.

b) The catalyst contains compounds of titanium-magnesium and aluminium.
c) Used as a 15 wt.% slurry in Isopar H. Available from Kyowa Chemical Ltd.
d) Time required to fall to 5% ethylene flow following injection of deactivator compound.
e) In Isopar H

## Claims

1. A method of homopolymerizing ethylene or interpolymerizing ethylene with one or more l-olefins or diolefins having at least three carbon atoms by subjecting the monomer(s) to polymerizing conditions in a reactor in the presence of a catalyst which comprises a transition metal derivative, and terminating the polymerization by adding a catalyst deactivator to the polymerization mixture or a part thereof, characterised in that the deactivator is
   (i) a natural hydrotalcite mineral,
   (ii) a carbonate-free hydrotalcite, or
   (iii) a hydrotalcite which contains a surface active agent.

2. A method according to claim 1, in which the polymerization mixture consists of a solution of the polymer in liquefied, unpolymerized, monomer(s), a portion of the polymerization mixture is removed from the reactor, the deactivator is added thereto, and the unpolymerized monomer(s) is/are removed by evaporation.

3. A method according to claim 1 or 2, in which from 0.1 to 10 moles of the deactivator are added per mole of metal in the catalyst.

4. A method according to any of claims 1 to 3, in which the deactivator is a hydrotalcite of the formula: $Mg_{4.5}Al_2(OH)_{15}.3.5H_2O$, $Mg_{1-x}Al_x(OH)_{2+x}.aH_2O$, or

$$Mg_{1-x}Al_x(OH)_2A^{b-}_{x/b}.dH_2O,$$

where $0<x\leqq0.5$, $0\leqq a<2$, b is a positive integer, and $d\geqq0$, and $A^{b-}$ is an anion having a valency of b.

Claims for the following Contracting State: NL:

1. A method of homopolymerizing ethylene or interpolymerizing ethylene with one or more l-olefins or diolefins having at least three carbon atoms by subjecting the monomer(s) to polymerizing conditions in a reactor in the presence of a catalyst which comprises a transition metal derivative, and terminating the polymerization by adding a catalyst deactivator to the polymerization mixture or a part thereof, characterised in that the deactivator is a natural hydrotalcite mineral or synthetic hydrotalcite-like material.

2. A method according to claim 1, in which the polymerization mixture consists of a solution of the polymer in liquefied, unpolymerized, monomer(s), a portion of the polymerization mixture is removed from the reactor, the deactivator is added thereto, and the unpolymerized monomer(s) is/are removed by evaporation.

3. A method according to claim 1 or 2, in which from 0.1 to 10 moles of the deactivator are added per mole of metal in the catalyst.

4. A method according to claims 1 to 3 in which the deactivator is a hydrotalcite of the formula: $Mg_6Al_2(OH)_{16}CO_3.4H_2O$, $Mg_{4.5}Al_2(OH)_{15}.3.5H_2O$, $Mg4_{.5}Al_2(OH)_{13}CO_3.3.5H_2O$, $Mg_{1-x}Al_x(OH)_{2+x}.aH_2O$, or

$$Mg_{1-x}Al_x(OH)_2A^{b-}_{x/b}.dH_2O,$$

where $0<x\leqq0.5$, $0\leqq a<2$, b is a positive integer, $d\geqq O$, and $A^{b-}$ is an anion having a valency of b.

**5.** A method according to any of claims 1 to 4, in which the hydrotalcite contains a surface active agent.

**Revendications**

**1.** Un procédé d'homopolymérisation de l'éthylène ou de copolymérisation de l'éthylène avec une ou plusieurs 1-oléfines ou dioléfines ayant au moins 3 atomes de carbone, en sou-mettant le ou les monomères à des conditions de polymérisation dans un réacteur en présence d'un catalyseur qui comprend un dérivé de métal de transition et en terminant la polymérisation par addition d'un désactivant du catalyseur au mélange de polymérisation ou à une partie dudit mélange, caractérisé en ce que le désactivant est

(i) une hydrotalcite minérale naturelle,
(ii) une hydrotalcite exempte de carbonate ou
(iii) une hydrotalcite qui contient un agent tensioactif.

**2.** Un procédé selon la revendication 1, dans lequel le mélange de polymérisation consiste en une solution du polymère dans le(s) monomère(s) liquéfié(s), non polymérisé(s), une portion du mélange de polymérisation est séparée du réacteur, on y ajoute le désactivant et on sépare le(s) monomère(s) non polymérisé(s) par évaporation.

**3.** Un procédé selon la revendication 1 ou 2, dans lequel on ajoute 0,1 à 10 mol du désactivant par mole de métal dans le catalyseur.

**4.** Un procédé selon l'une quelconque des revendications 1 à 3, dans lequel le désactivant est une hydrotalcite de formule :

$Mg_{4,5}Al_2(OH)_{15},3,5H_2O$,
$Mg_{1-x}Al_x(OH)_{2+x},aH_2O$ ou

$$Mg_{1-x}Al_x(OH)_2A^{b-}_{x/b},dH_2O,$$

dans lesquelles $0<x\leqq0,5$, $0\leqq a<2$, b est un entier positif et $d\geqq0$ et $A^{b-}$ est un anion de valence b.

Revendications pour l'Etat contractant suivant : NL

**1.** Un procédé d'homopolymérisation de l'éthylène ou de copolymérisation de l'éthylène avec une ou plusieurs l-oléfines ou dioléfines ayant au moins 3 atomes de carbone en soumettant le ou les monomères à des conditions de polymérisation dans un réacteur en présence d'un catalyseur qui comprend un dérivé de métal de transition et en terminant la polymérisation par addition d'un désactivant du catalyseur au mélange de polymérisation ou à une partie dudit mélange,caractérisé en ce que le désactivant est une hydrotalcite minérale naturelle ou un matériau synthétique du type hydrotalcite.

**2.** Un procédé selon la revendication 1, dans lequel le mélange de polymérisation consiste en une solution du polymère dans le(s) monomère(s) liquéfié(s), non polymérisé(s), une portion du mélange de polymérisation est séparée du réacteur, on y ajoute le désactivant et on sépare le(s) monomère(s) non polymérisé(s) par évaporation.

**3.** Un procédé selon la revendication 1 ou 2, dans lequel on ajoute 0,1 à 10 mol du désactivant par mole de métal dans le catalyseur.

**4.** Un procédé selon l'une quelconque des revendications 1 à 3, dans lequel le désactivant est une hydrotalcite de formule :

$Mg_6Al_2(OH)_{16}CO_3,4H_2O$,

$Mg_{4,5}Al_2(OH)_{15},3,5H_2O$,
$Mg_{4,5}Al_2(OH)_{13}CO_3,3,5H_2O$,
$Mg_{1-x}Al_x(OH)_{2+x},aH_2O$ ou

$$Mg_{1-x}Al_x(OH)_2A^{b-}_{x/b},dH_2O,$$

dans lesquelles $0<x\leqq0,5$, $0\leqq a<2$, b est un entier positif et $d\geqq0$ et $A^{b-}$ est un anion de valence b.

**5.** Un procédé selon l'une quelconque des revendications 1 à 4, dans lequel l'hydrotalcite contient un agent tensioactif.

## Ansprüche

**1.** Verfahren zur Ethylenhomopolymerisation oder Ethyleninterpolymerisation mit einem oder mehreren l-Olefinen oder Diolefinen, die wenigstens drei Kohlenstoffatome enthalten, durch Unterwerfen des Momomers/der Monomere unter Polymerisationsbedingungen in einem Reaktor in der Anwesenheit eines Katalysators, der ein Übergangsmetallderivat enthält, und Beenden der Polymerisation durch Zugabe eines Katalysatordesaktivators zur Polymerisationsmischung oder einem Teil davon,
**dadurch gekennzeichnet,**
daß der Desaktivator
1) ein natürliches Hydrotalkitmineral
2) ein karbonatfreies Hydrotalkit oder
3) ein Hydrotalkit, das ein oberflächenaktives Reagenz enthält, ist.

**2.** Verfahren nach Anspruch 1,
bei dem die Polymerisationsmischung aus einer Lösung des Polymers in verflüssigten unpolymerisierten Monomer(en) besteht, ein Teil der Polymerisationsmischung aus dem Reaktor entfernt wird, der Desaktivator dazu hinzugegeben wird und das unpolymerisierte Monomer bzw. die Monomere durch Abdampfen entfernt wird/werden.

**3.** Verfahren nach Anspruch 1 oder 2,
bei dem von 0,1 bis 10 Mol des Desaktivators pro Mol Metall des Katalysators zugegeben werden.

**4.** Verfahren nach einem der Ansprüche 1 bis 3,
bei dem der Desaktivator ein Hydrotalkit der Formel:
$Mg_{4.5}Al_2(OH)_{15}$` $3,5H_2O$, $Mg_{1-x}Al_x(OH)_{2+x}.aH_2O$, oder

$$Mg_{1-x}Al_x(OH)_2A^{b-}_{x/b}\cdot dH_2O$$

ist, wobei $0<x\leqq0,5$, $0\leqq a<2$, b eine positive ganze Zahl ist, und $d\geqq O$ und $A^{b-}$ ein Anion ist, das die Wertigkeit von b hat.

Patentansprüche für folgenden Vertragsstaat: NL:

**1.** Verfahren zur Ethylenhomopolymerisation oder Ethyleninterpolymerisation mit einem oder mehreren l-Olefinen oder Diolefinen, die wenigstens drei Kohlenstoffatome enthalten, durch Unterwerfen des Momomers/der Monomere unter Polymerisationsbedingungen in einem Reaktor in der Anwesenheit eines Katalysators, der ein Übergangsmetallderivat enthält, und Beenden der Polymerisation durch Zugabe eines Katalysatordesaktivators zur Polymerisationsmischung oder einem Teil davon,
**dadurch gekennzeichnet,**
daß der Desaktivator ein natürliches Hydrotalkitmineral oder ein synthetisches hydrotalkitartiges Mineral ist.

**2.** Verfahren nach Anspruch 1,
bei dem die Polymerisationsmischung aus einer Lösung des Polymers in verflüssigten unpolymerisierten Monomer(en) besteht, ein Teil der Polymerisationsmischung aus dem Reaktor entfernt wird, der Desaktivator dazu hinzugegeben wird und das unpolymerisierte Monomer bzw. die Monomere durch Abdampfen entfernt wird/werden.

**3.** Verfahren nach Anspruch 1 oder 2,
bei dem von 0,1 bis 10 Mol des Desaktivators pro Mol Metall des Katalysators zugegeben werden.

**4.** Verfahren nach einem der Ansprüche 1 bis 3,
bei dem der Desaktivator ein Hydrotalkit der Formel:
$Mg_{4,5}Al_2(OH)_{15}.3,5H_2O$, $Mg_{1-x}Al_x(OH)_{2+x}.aH_2O$, oder

$$Mg_{1-x}Al_x(OH)_2A^{b-}_{x/b}\cdot dH_2O$$

ist, wobei $0<x\leqq 0,5$, $0\leqq a<2$, b eine positive ganze Zahl ist, und $d\geqq 0$ und $A^{b-}$ ein Anion ist, das die Wertigkeit von b hat.

**5.** Verfahren nach einem der Ansprüche 1 bis 4, bei dem das Hydrotalkit ein oberflächenaktives Reagenz enthält.